# EUROPEAN PATENT APPLICATION

(11) **EP 4 716 034 A1**
(43) Date of publication of application: **25.03.2026**
(21) Application number: 24807275.3
(22) Date of filing: 16.05.2024
(51) Int. Cl.: H01S 3/10, G01J 1/02, H01S 3/17, H01S 5/30, H10N 15/00

(54) **OPTICAL AMPLIFIER AND LASER LIGHT SOURCE**

(30) Priority: 17.05.2023 JP 2023081418; 04.10.2023 JP 2023173140
(71) Applicant: Keio University, Tokyo, 108-8345 (JP)
(72) Inventor: MAKI, Hideyuki, Yokohama-shi, Kanagawa 223-8522 (JP)
(74) Representative: Piotrowicz, Pawel Jan Andrzej
(86) International application number: PCT/JP2024/018233
(87) International publication number: WO 2024/237325

(57) **Abstract**

An optical amplifier includes: a substrate; a first optical waveguide formed over the substrate; a semiconductor carbon nanotube layer covering a predetermined region of the first optical waveguide; and an excitation structure configured to excite the semiconductor carbon nanotube layer. Signal light is amplified by an excited state of electrons in the semiconductor carbon nanotube layer and stimulated emission resulting from incidence of the signal light into the predetermined region.

## Description

### TECHNICAL FIELD

The present invention relates to an optical amplifier and a laser light source, and particularly to an optical amplifier and a laser light source in each of which a semiconductor carbon nanotube and a silicon photonics waveguide or a resonator are combined.

### BACKGROUND ART

In long-distance optical communications, erbium (Er)-doped fiber amplifiers (EDFAs) are generally used to amplify optical signals that are attenuated during transmission. Optical amplification is one of the important technologies in large-capacity optical communications. The length of an Er-doped fiber used in an EDFA is typically several tens of meters, and the device size is as large as a desktop size. In the future, in order to implement large-capacity and high-integration information communication devices, it is desirable to achieve an ultra-compact optical amplifier that operates on a chip.

Optical amplifiers are used not only for repeaters disposed in optical transmission paths but also for light sources. A mode-locked laser in which an optical amplifier including an Er-doped fiber is disposed in a resonator so as to amplify light circulating in the resonator is known (for example, see Patent Document 1). In mode-locked lasers, carbon nanotubes are often used as super-saturable absorbers. Light-emitting devices based on spontaneous emission in which carbon nanotubes and silicon photonics resonators are combined have been proposed (for example, see Non-Patent Documents 1 and 2).

### RELATED-ART DOCUMENTS

### PATENT DOCUMENTS

Patent Document 1: Japanese Unexamined Patent Publication No. 2022-139361

### NON-PATENT DOCUMENTS

Non-Patent Document 1: N. Higuchi, H. Niiyama, K. Nakagawa, H. Maki, "Efficient and Narrow-Linewidth Photoluminescence Devices Based on Single-Walled Carbon Nanotubes and Silicon Photonics," ACS Appl. Nano Mater. 3, 7678-7684 (2020)
Non-Patent Document 2: R. Tokunaga, K. Kinoshita, R. Imamura, K. Nagashima, R. Imafuku, K. Nakagawa, T. Tanabe, and H. Maki, "Carbon Nanotubes Coupled with Silica Toroid Microcavities as Emitters for Silicon-Integrated Photonics," ACS Appl. Nano Mater. 5, 14328-14335 (2022)

### SUMMARY OF THE INVENTION

### PROBLEM TO BE SOLVED BY THE INVENTION

In recent years, on-chip photonic integrated circuits such as silicon photonics have attracted attention. In current on-chip light sources, a compound semiconductor laser chip is bonded to a silicon photonics substrate with an adhesive or the like. Because a large laser chip formed of a compound semiconductor is bonded to a silicon photonics substrate, high integration is difficult. This fact is one of the reasons why practical application of silicon photonics has not progressed. Because a compound semiconductor cannot be grown directly on silicon, a laser light source cannot be integrated on a silicon substrate by direct growth. Not only laser light sources, but also optical amplifiers doped with ions such as of Er are very difficult to implement in silicon photonics.

One object of the present invention is to provide an optical amplifier and a laser light source that can be readily integrated on a substrate.

### MEANS TO SOLVE THE PROBLEM

An optical amplifier and a laser light source that can be readily integrated on a substrate are achieved by using a semiconductor carbon nanotube as a part of a gain medium (or an active laser medium). According to one aspect, an optical amplifier includes:
a substrate;
a first optical waveguide formed over the substrate;
a semiconductor carbon nanotube layer covering a predetermined region of the first optical waveguide; and
an excitation structure configured to excite the semiconductor carbon nanotube layer, wherein
signal light is amplified by an excited state of electrons in the semiconductor carbon nanotube layer and stimulated emission resulting from incidence of the signal light into the predetermined region.

According to another aspect, a laser light source includes:
a substrate;
a first optical waveguide formed over the substrate;
a resonator disposed over the substrate and configured to be optically coupled to the first optical waveguide;
a semiconductor carbon nanotube layer covering a portion or an entirety of the resonator; and
an excitation structure configured to excite the semiconductor carbon nanotube layer, wherein
the resonator confines light generated by excitation of carriers by the excitation structure, and
the first optical waveguide outputs laser light generated by the confinement of the light by the resonator and stimulated emission resulting from a population inversion of the semiconducting carbon nanotube layer.

### EFFECTS OF THE INVENTION

An optical amplifier and a laser light source that can be readily integrated on a substrate are achieved.

### BRIEF DESCRIPTION OF THE DRAWINGS

[FIG. 1A] FIG. 1A is a schematic plan view of an optical amplifier according to a first embodiment; [FIG. 1B] FIG. 1B is a cross-sectional view taken along the line A-A of FIG. 1A;
[FIG. 2] FIG. 2 is a microscopic image of an optical waveguide used in the optical amplifier of FIG. 1A and FIG. 1B;
[FIG. 3A] FIG. 3A is a schematic diagram illustrating an example of an excitation structure of FIG. 1A and FIG. 1B;
[FIG. 3B] FIG. 3B is a schematic diagram illustrating another example of the excitation structure;
[FIG. 4A] FIG. 4A is a schematic diagram illustrating still another example of the excitation structure;
[FIG. 4B] FIG. 4B is a schematic diagram illustrating still another example of the excitation structure;
[FIG. 5] FIG. 5 is a diagram illustrating the excitation light power dependence of the gain with respect to the signal input of the optical amplifier according to the first embodiment;
[FIG. 6A] FIG. 6A is a schematic plan view of an optical amplifier according to a second embodiment;
[FIG. 6B] FIG. 6B is a cross-sectional view taken along the line B-B of FIG. 6A;
[FIG. 7A] FIG. 7A is an image of an optical waveguide and a resonator used in the optical amplifier of FIG. 6A and FIG. 6B;
[FIG. 7B] FIG. 7B is an image of an optical waveguide and a resonator used in the optical amplifier of FIG. 6A and FIG. 6B;
[FIG. 8] FIG. 8 is a diagram illustrating the gain characteristics with respect to the signal input of the optical amplifier according to the second embodiment;
[FIG. 9A] FIG. 9A is a diagram illustrating an example configuration of a resonator that can be used in the optical amplifier;
[FIG. 9B] FIG. 9B is a diagram illustrating an example configuration of a resonator that can be used in the optical amplifier;
[FIG. 9C] FIG. 9C is a diagram illustrating an example configuration of a resonator that can be used in the optical amplifier;
[FIG. 9D] FIG. 9D is a diagram illustrating an example configuration of a resonator that can be used in the optical amplifier;
[FIG. 9E] FIG. 9E is a diagram illustrating an example configuration of a resonator that can be used in the optical amplifier;
[FIG. 9F] FIG. 9F is a diagram illustrating an example configuration of a resonator that can be used in the optical amplifier;
[FIG. 10A] FIG. 10A is a schematic plan view of an optical amplifier according to a modification of the second embodiment;
[FIG. 10B] FIG. 10B is a schematic plan view of the optical amplifier according to the modification of the second embodiment;
[FIG. 11] FIG. 11 is an image of optical waveguides and a resonator of FIG. 10A and FIG. 10B;
[FIG. 12A] FIG. 12A is a diagram illustrating an example output configuration of amplified light;
[FIG. 12B] FIG. 12B is a diagram illustrating an example output configuration of amplified light;
[FIG. 12C] FIG. 12C is a diagram illustrating an example output configuration of amplified light;
[FIG. 13A] FIG. 13A is a schematic view of a laser light source according to a third embodiment;
[FIG. 13B] FIG. 13B is a schematic view of a laser light source according to the third embodiment;
[FIG. 14A] FIG. 14A is a schematic view of a laser light source by current injection;
[FIG. 14B] FIG. 14B is a schematic view of the laser light source by current injection;
[FIG. 15] FIG. 15 is a schematic view of a laser light source using a molecularly modified carbon nanotube according to a modification of the third embodiment;
[FIG. 16A] FIG. 16A is an energy diagram illustrating laser oscillation from localized exciton levels by a molecularly modified carbon nanotube;
[FIG. 16B] FIG. 16B is an energy diagram illustrating laser oscillation from localized exciton levels by a molecularly modified carbon nanotube;
[FIG. 17] FIG. 17 is an emission spectrum diagram of a molecularly modified carbon nanotube; and
[FIG. 18] FIG. 18 is an image illustrating an example configuration using a toroid resonator and optical fibers.

### MODE FOR CARRYING OUT THE INVENTION

An optical amplifier and a laser light source according to embodiments will be described below with reference to the drawings. The following description is provided for the purpose of embodying the technical ideas of the present invention, but the present invention is not limited to the described configurations and numerical values. In the drawings, components having the same functions may be denoted by the same reference numerals, and a duplicate description thereof may be omitted. Partial replacement or combination of components between different embodiments or configuration examples is possible. The sizes, positional relationships, and the like of members illustrated in the drawings may be exaggerated to facilitate understanding of the present invention.

### <First Embodiment>

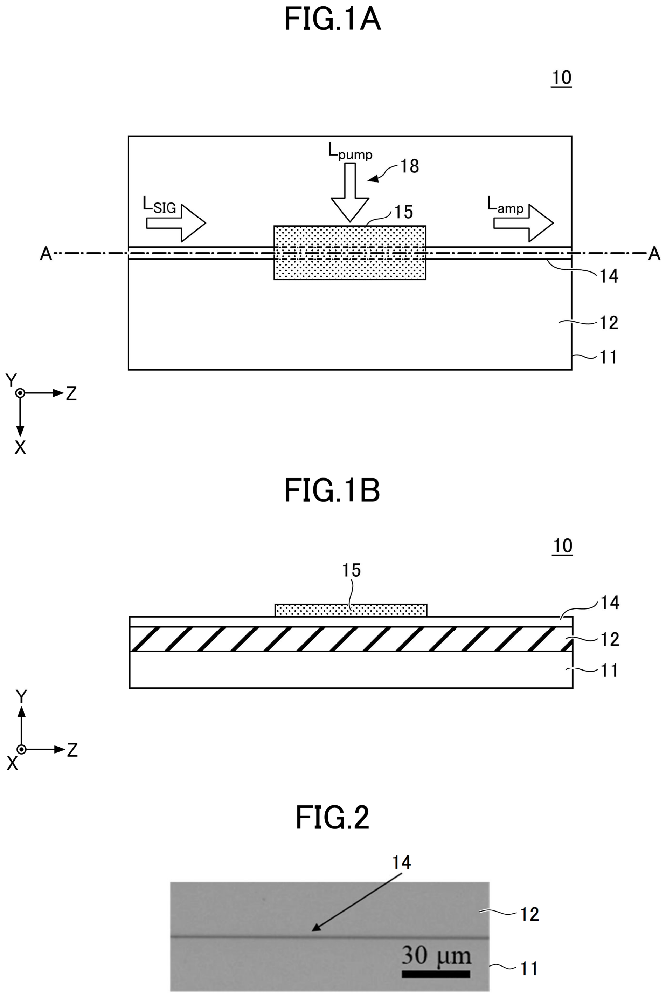

FIG. 1A is a schematic plan view of an optical amplifier 10 according to a first embodiment. FIG. 1B is a cross-sectional view taken along the line A-A of FIG. 1A. In a coordinate system of FIG. 1A and FIG. 1B, a propagation direction of light is defined as a Z direction, a thickness direction or a lamination direction of a substrate 11 is defined as a Y direction, and a direction orthogonal to the YZ plane is defined as an X direction. The optical amplifier 10 includes the substrate 11, a first optical waveguide 14 formed over the substrate 11, a semiconductor carbon nanotube layer 15 covering a predetermined region of the first optical waveguide 14, and an excitation structure 18 configured to excite the semiconductor carbon nanotube layer 15. A material of the first optical waveguide 14 can be selected in accordance with the wavelength used. In the case of transmitting light in the 1.3 µm band or the 1.5 µm band used in optical communications, the waveguide is formed of silicon (Si), silicon nitride (SiN), silica, or a polymer material. Ge can be used at a wavelength of approximately 2 µm or longer. In this case, an insulating layer 12 having a refractive index lower than that of the waveguide may be disposed as a lower cladding on the substrate 11, and the first optical waveguide 14 may be formed on the insulating layer 12. A cladding may be deposited on the first optical waveguide 14 such that the entire first optical waveguide 14 is covered by a cladding layer. Alternatively, air may be used as a cladding. The wavelength of light to be transmitted may be any wavelength as long as light is transmitted through the optical waveguide. Examples of the wavelength include a near-infrared wavelength of 1.1 µm or longer, which is typically used in silicon photonics, a wavelength of 850 nm or longer, which is used for silicon nitride, a visible light wavelength or longer, which is used for silica and polymer, and a wavelength of approximately 2 µm or longer, which is used for Ge.

In a case where the first optical waveguide 14 is formed of Si, an SOI substrate may be used as the substrate 11. A silicon oxide film of the SOI substrate may be used as the insulating layer 12, and a silicon layer on the silicon oxide film may be etched so as to form the first optical waveguide 14. Light is confined in the first optical waveguide 14 by the lower insulating layer 12 and an air layer surrounding the first optical waveguide 14. Instead of the air layer, the entire surface of the substrate 11 included in the optical amplifier 10 may be covered by a protective layer having a refractive index lower than that of the first optical waveguide 14. In this case, the protective layer also functions as an upper cladding.

The semiconductor carbon nanotube layer 15 can be directly formed on the insulating layer 12, which is disposed on the substrate 11, and the first optical waveguide 14. Unlike conventional luminescent centers such as compound semiconductors and rare earth elements, a carbon nanotube (hereinafter abbreviated as a "CNT") of a semiconductor can be easily formed on a chip by any of various coating methods such as spin coating, dip coating, and spraying. Further, because the semiconductor CNT layer 15 can be directly disposed on the first optical waveguide 14, the semiconductor CNT layer 15 and the first optical waveguide 14 can be directly optically coupled by an evanescent field. The semiconductor CNT layer 15 may be a molecularly modified CNT, as will be described later. The molecularly modified CNT will be described in detail in a third embodiment. By taking advantage of the above-described features, the first embodiment provides the optical amplifier 10 that uses the semiconductor CNT layer 15 and is integrated on the substrate 11.

The excitation structure 18 excites the semiconductor CNT layer 15 deposited on the first optical waveguide 14 with excitation light Lₚᵤₘₚ. In a state in which electrons in the semiconductor CNT layer 15 are excited, signal light L_{SIG} to be amplified is caused to be incident into the first optical waveguide 14. The wavelength of the excitation light Lₚᵤₘₚ is shorter than the wavelength of the signal light L_{SIG}. The signal light L_{SIG} is amplified by the excited state of the electrons in the semiconductor CNT and stimulated emission resulting from the incidence of the signal light L_{SIG}, and amplified light Lₐₘₚ synchronized with the signal light L_{SIG} is obtained.

As will be described later, the excitation light Lₚᵤₘₚ may be emitted to the semiconductor CNT layer 15 from above a chip, that is, from above the substrate 11, or the excitation light Lₚᵤₘₚ may be introduced into the first optical waveguide 14 over the substrate 11. In the latter case, any of the following configurations can be employed.
(1) An excitation light source is provided outside the chip, the excitation light is incident into a fiber, and the excitation light and the signal light are multiplexed by an optical fiber coupler provided outside the chip.
(2) The chip is provided with two incident ports for the signal light and the excitation light, and the signal light and the excitation light are incident into the respective incident ports and multiplexed in the chip.
(3) The excitation light source is provided inside the chip, and the excitation light is multiplexed and incident into the optical waveguide over the substrate by a coupler or the like.
(4) In a case where a resonator is used as in an embodiment described later, two optical waveguides are optically coupled to the resonator, and the excitation light and the signal light are incident into the one resonator from the respective optical waveguides.

Further, with respect to the introduction of the signal light, any of the following configurations can be employed.
(a) The signal light is introduced from the outside of the chip, and the signal light and the excitation light are multiplexed by an optical fiber coupler provided outside the chip.
(b) The chip is provided with two incident ports for the signal light and the excitation light, and the signal light and the excitation light are incident into the respective incident ports and multiplexed in the chip.
(c) The signal light is generated on the chip, and the signal light is multiplexed and incident into the optical waveguide on the chip.
(d) In a case where a resonator is used as in an embodiment described later, two optical waveguides are optically coupled to the resonator, and the excitation light and the signal light are incident into the one resonator from the respective optical waveguides.
Various configurations can be employed by combining any of (1) to (4) and (a) to (d).

In a case where the excitation light Lₚᵤₘₚ is introduced into the first optical waveguide 14 over the substrate 11, the excitation light Lₚᵤₘₚ propagates from the left end of FIG. 1A and FIG. 1B through the first optical waveguide 14 and reaches a region where the semiconductor CNT layer 15 is provided. Because the first optical waveguide 14 and the semiconductor CNT layer 15 are coupled by an evanescent field, electrons in the semiconductor CNT are excited by the incidence of the excitation light Lₚᵤₘₚ. By inputting the signal light L_{SIG} to be amplified into the first optical waveguide 14 in a state in which the electrons in the semiconductor CNT layer 15 are excited, the signal light L_{SIG} can be amplified by stimulated emission. The amplified light Lₐₘₚ propagates through the first optical waveguide 14 in the same direction.

FIG. 2 is an image of the first optical waveguide 14 used in the optical amplifier 10 of FIG. 1A and FIG. 1B. In this example, the substrate 11 is a silicon substrate or an SOI substrate, and the first optical waveguide 14 on the insulating layer 12 is formed of a Si wire. When the Si wire is used in a single mode, the width and the height of the Si wire are, for example, 0.1 µm to 1.0 µm, and the width and the height of the Si wire can be appropriately designed according to the application. One or both of the height or the width of the Si wire can be greater when the Si wire is used in a multimode than when in a single mode. In general, the optical coupling efficiency between the semiconductor CNT layer 15 and a portion of the Si wire coupled to the semiconductor CNT layer 15 is higher when the Si wire is used in a single mode. The semiconductor CNT layer 15 is disposed in a desired region covering the first optical waveguide 14, which is the Si wire, of FIG. 2. As described above, the semiconductor CNT layer 15 is easily formed. For example, the semiconductor CNT layer 15 of a desired pattern can be formed by a screen printing method using CNT ink in which CNTs are dispersed.

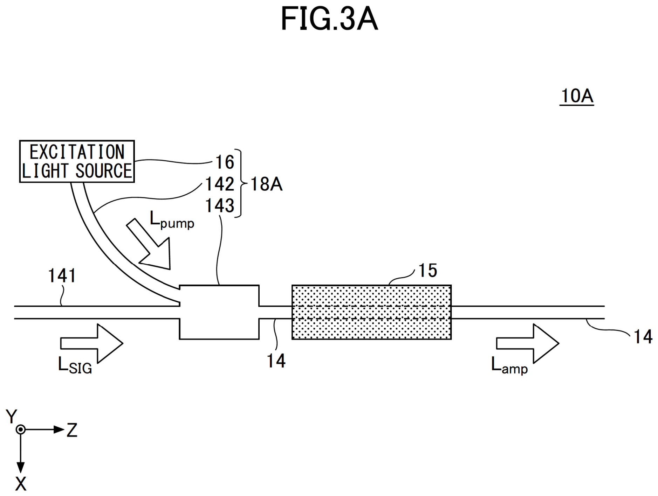

FIG. 3A is a schematic diagram illustrating an excitation structure 18A, which is an example of the excitation structure 18. The excitation structure 18A of an optical amplifier 10A includes an excitation light source 16, a second optical waveguide 142 configured to guide, over the substrate 11, excitation light Lₚᵤₘₚ emitted from the excitation light source 16, and a coupler 143 configured to couple the second optical waveguide 142 and the first optical waveguide 14. The excitation light Lₚᵤₘₚ multiplexed by the coupler 143 and propagated to a region directly under the semiconductor CNT layer 15 is evanescently coupled to the semiconductor CNT layer 15 and excites electrons in the semiconductor CNT layer 15. The excitation light source 16 is provided over the substrate 11 or outside the substrate 11. In a case where the excitation light source 16 is provided outside the substrate 11, a spot-size converter, a grating coupler, or the like may be formed on the incident side of the second optical waveguide 142 of the substrate 11 so as to couple the excitation light Lₚᵤₘₚ into the second optical waveguide 142 over the substrate 11, or an optical fiber and a condenser lens may be used to couple the excitation light Lₚᵤₘₚ into the second optical waveguide 142. Alternatively, the excitation light Lₚᵤₘₚ emitted from the excitation light source 16 may be directly coupled into the second optical waveguide 142 over the substrate 11 at the end surface or the surface of the substrate 11. In a case where the excitation light is coupled into the second optical waveguide 142 at the surface of the substrate 11, a grating coupler connected to the second optical waveguide 142 may be formed over the surface of the substrate 11. The excitation light is introduced from the second optical waveguide 142 into the first optical waveguide 14. In a case where the second optical waveguide 142 and the first optical waveguide 14 are Si waveguides, the wavelength of the excitation light Lₚᵤₘₚ is shorter than the wavelength of signal light L_{SIG} and is longer than 1.1 µm, which is the absorption edge wavelength of Si.

The excitation light Lₚᵤₘₚ incident into the first optical waveguide 14 from the second optical waveguide 142 is evanescently coupled to the semiconductor CNT layer 15 and excites electrons in the semiconductor CNT. In this state, the signal light L_{SIG} is introduced from a signal light input optical waveguide 141 into the first optical waveguide 14. When the signal light L_{SIG} passes through a region of the first optical waveguide 14 directly under the semiconductor CNT layer 15, the first optical waveguide 14 and the semiconductor CNT layer 15 are coupled by an evanescent field. The excited electrons transition to a lower energy level by the incidence of the signal light L_{SIG}, and the corresponding energy is emitted as electromagnetic radiation. The signal light L_{SIG} is amplified by this stimulated emission resulting from the incidence of the signal light L_{SIG}. Amplified light Lₐₘₚ having the same phase, the same frequency, and the same polarization state as the signal light L_{SIG} propagates through the first optical waveguide 14 in the same direction. In the configuration of FIG. 3A, the excitation light Lₚᵤₘₚ can be guided from the second optical waveguide 142 into the first optical waveguide 14 over the substrate 11, and a waveguide region directly under the semiconductor CNT layer 15 can be efficiently excited with a very compact configuration.

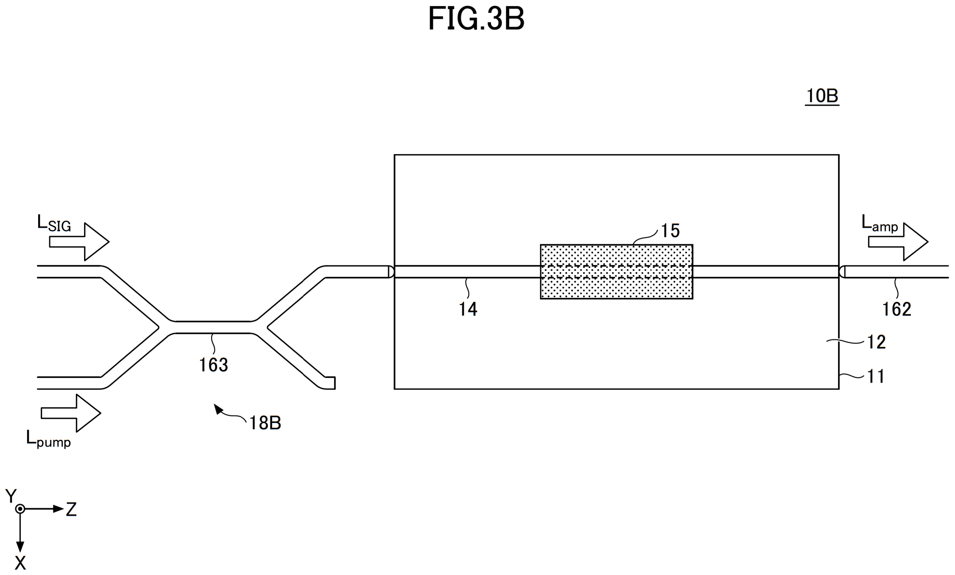

FIG. 3B is a schematic diagram illustrating an excitation structure 18B, which is another example of the excitation structure 18. In a case where the excitation light source 16 is located outside the substrate 11, signal light and excitation light may be multiplexed by an optical fiber. The excitation structure 18B of an optical amplifier 10B uses an optical fiber coupler 163. Excitation light Lₚᵤₘₚ is incident into one input port of the optical fiber coupler 163, signal light L_{SIG} is incident into the other input port, and the excitation light Lₚᵤₘₚ and the signal light L_{SIG} are multiplexed by the optical fiber coupler 163. One output port of the optical fiber coupler 163 is optically coupled to the first optical waveguide 14 over the substrate 11. The other output port of the optical fiber coupler 163 may be terminated.

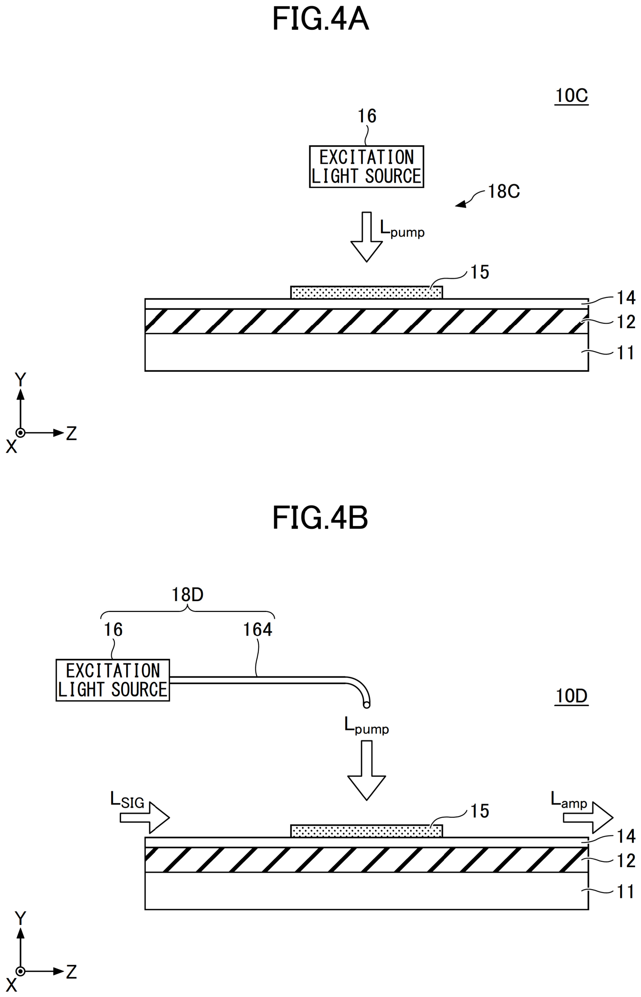

FIG. 4A and FIG. 4B are schematic diagrams illustrating excitation structures 18C and 18D, which are still other examples of the excitation structure 18 of FIG. 1A and FIG. 1B. In the excitation structure 18C of an optical amplifier 10C, the semiconductor CNT layer 15 is irradiated with excitation light Lₚᵤₘₚ from above the substrate 11. By attaching a laser light source, an LED, a lamp, or the like, as the excitation light source 16 above the substrate 11, the semiconductor CNT layer 15 over the substrate 11 can be directly irradiated with the light. FIG. 4B illustrates the excitation structure 18D of an optical amplifier 10D. Excitation light Lₚᵤₘₚ emitted from the external excitation light source 16 may be guided to the vicinity of the substrate 11 by a fiber waveguide 164 such as an optical fiber with a lens, and the semiconductor CNT layer 15 may be irradiated with the light from above. When signal light L_{SIG} is incident into a region of the first optical waveguide 14 directly under the semiconductor CNT layer 15 in a state in which electrons in the semiconductor CNT are excited by each of the excitation structures 18C and 18D, stimulated emission occurs, and the signal light L_{SIG} is amplified. Amplified light Lₐₘₚ having the same phase, the same frequency, and the same polarization state as the signal light L_{SIG} propagates through the first optical waveguide 14 in the same direction.

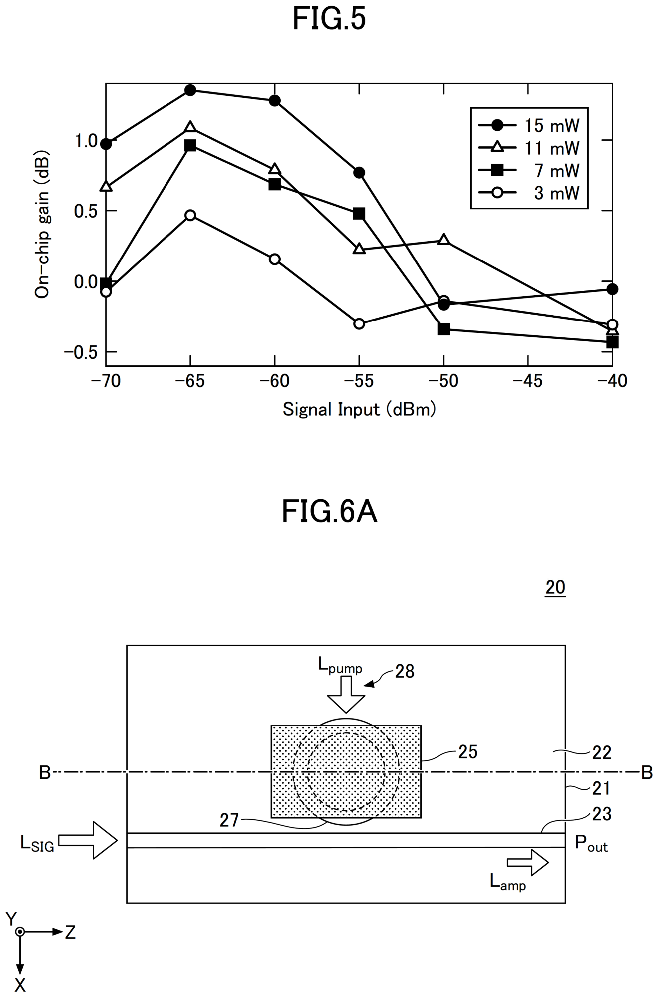

FIG. 5 is a diagram illustrating the excitation light power dependence of the gain with respect to the signal input of the optical amplifier 10 according to the first embodiment. The horizonal axis represents the signal input power (dBm) to the optical amplifier 10, and the vertical axis represents the chip gain, that is, the gain (dB) of the optical amplifier 10. The power of excitation light Lₚᵤₘₚ is changed to 3 mW, 7 mW, 11 mW, and 15 mW. For weak signal light having a power higher than -65 dBm and lower than -60 dBm, the excitation light power is proportional to the amplification factor, and the gain can be controlled by adjusting the excitation light power. When the power of the input signal light is higher than -65 dBm and lower than - 52 dBm, the signal light can be amplified by using excitation light having a power of 7 mW or more. The input signal power of the optical amplifier 10, gain to be obtained, and the excitation light power and the signal light power necessary to achieve amplification are not limited to the values indicated in the graph of FIG. 5. By improving the design of the whole device, it is possible to obtain greater amplification and improve the gain characteristics, or to obtain gain with a smaller excitation power and larger signal light. Unlike light emission by spontaneous emission disclosed in Non-Patent Documents 1 and 2, optical amplification by stimulated emission can be achieved.

In the first embodiment, by combining the first optical waveguide 14 over the substrate 11 with the semiconductor CNT layer 15, the minute optical amplifier 10 can be implemented on the substrate 11. In particular, it is possible to combine with a silicon photonics waveguide, and the minute optical amplifier 10 can be implemented on a Si chip and can be easily integrated with another optical circuit.

### <Second Embodiment>

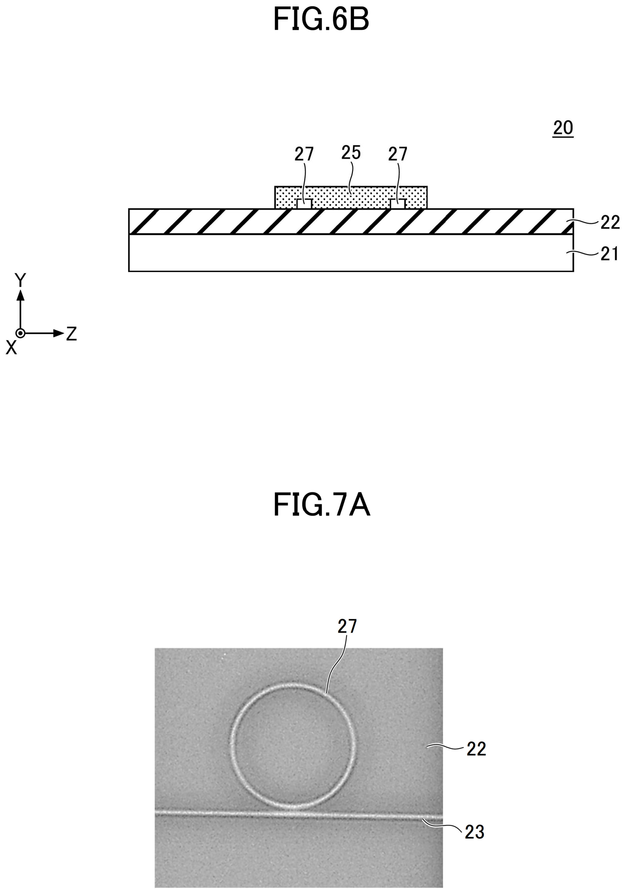

FIG. 6A is a schematic plan view of an optical amplifier 20 according to a second embodiment. FIG. 6B is a cross-sectional view taken along the line B-B of FIG. 6A. In a coordinate system of FIG. 6A and FIG. 6B, a light propagation direction of a waveguide 23 is defined as a Z direction, a thickness direction or a lamination direction of a substrate 11 is defined as a Y direction, and a direction orthogonal to the YZ plane is defined as an X direction. The second embodiment provides the optical amplifier 20 in which a resonator over the substrate 21 is combined with a semiconductor CNT.

The optical amplifier 20 includes the substrate 21, a first optical waveguide 23 formed over the substrate 21, a resonator 27 disposed over the substrate 21 and configured to be optically coupled to the first optical waveguide 23, a semiconductor CNT layer 25 covering a portion of or the entirety of the resonator 27, and an excitation structure 28 configured to excite the semiconductor CNT layer 25. Signal light L_{SIG} is amplified by an excited state of electrons in the semiconductor CNT layer 25 and stimulated emission resulting from the signal light L_{SIG} coupled from the first optical waveguide 23 to the resonator 27. The semiconductor CNT layer 25 may be a molecularly modified CNT layer.

The resonator 27 may adopt any configuration as long as a resonance wavelength can be defined over the substrate 11. The resonator 27 may be a ring resonator as illustrated in FIG. 6A and FIG. 6B. Alternatively, the resonator 27 can be a disk resonator, a racetrack resonator, a toroid resonator, a photonic-crystal resonator, a whispering gallery mode resonator, a nanobeam resonator, or any other resonator optically coupled to a one-dimensional waveguide.

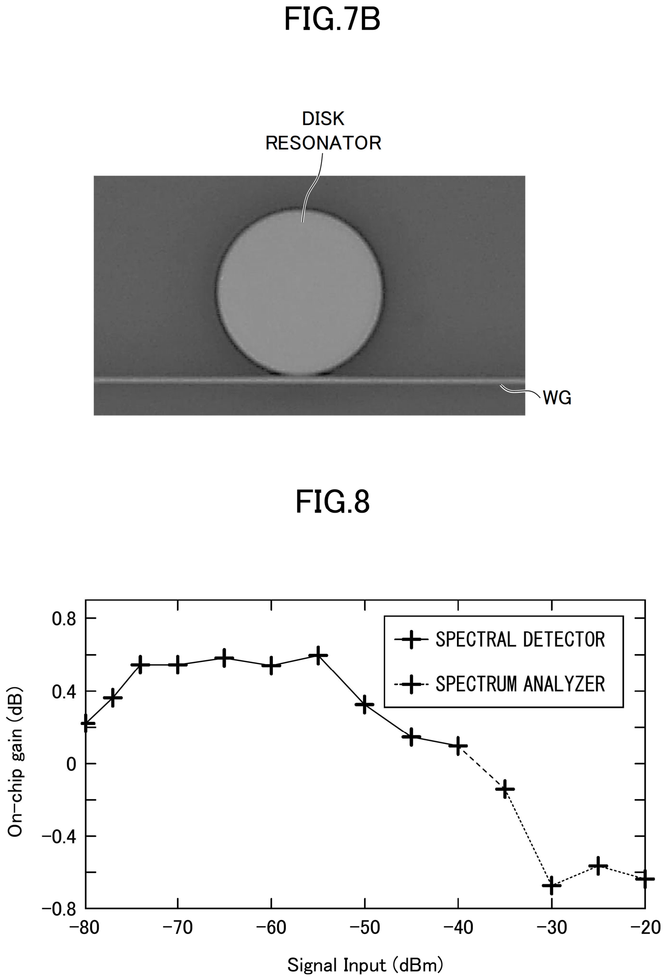

FIG. 7A and FIG. 7B are images of optical waveguides and resonators used in the optical amplifier 20 according to the second embodiment. In FIG. 7A, a ring resonator 27 as illustrated in FIG. 6A and FIG. 6B is disposed in proximity to the first optical waveguide 23. In FIG. 7B, a disk resonator is disposed in proximity to an optical waveguide (WG). In either configuration, at least a portion of the resonator is covered by the semiconductor CNT layer 25, and light having a predetermined wavelength, of the signal light guided through the optical waveguide, can be amplified by exciting the semiconductor CNT.

FIG. 8 illustrates the gain characteristics with respect to the signal input of the optical amplifier 20 according to the second embodiment. The horizontal axis represents the signal input power (dBm) to the optical amplifier 20, and the vertical axis represents the chip gain, that is, the gain (dB) of the optical amplifier 20. In a region where the power of input signal light is -40 dBm or less, the gain is calculated based on measurement results by a spectral detector. In a region where the power exceeds -40 dBm, the gain is calculated based on measurement results by a spectrum analyzer. As a resonator, the ring resonator 27 illustrated in FIG. 7A is used. The ring resonator 27 has a linewidth of 1 µm, a diameter of 40 µm, and an excitation light power of 15 mW. For a low-power signal light input, a maximum optical amplification of approximately 0.6 dB is obtained. The input signal power of the optical amplifier 20, the gain to be obtained, and the excitation light power and the signal light power necessary to achieve amplification are not limited to the values indicated in the graph of FIG. 8. By improving the design of the resonator 27, which is the ring resonator, and the design of the whole device, it is possible to obtain greater amplification and improve the gain characteristics, or to obtain gain with a smaller excitation power and larger signal light.

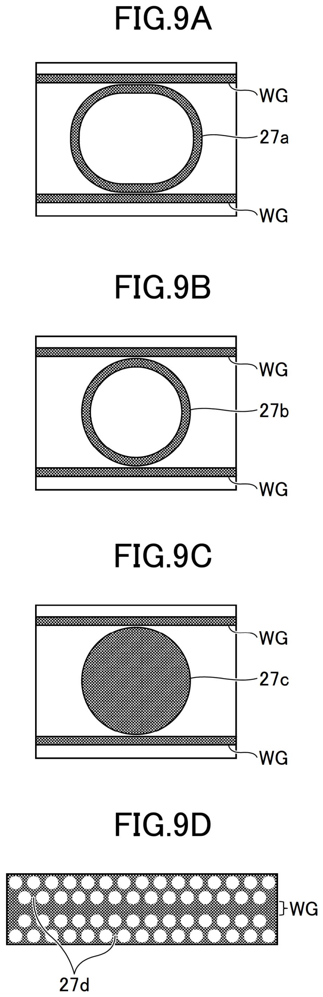

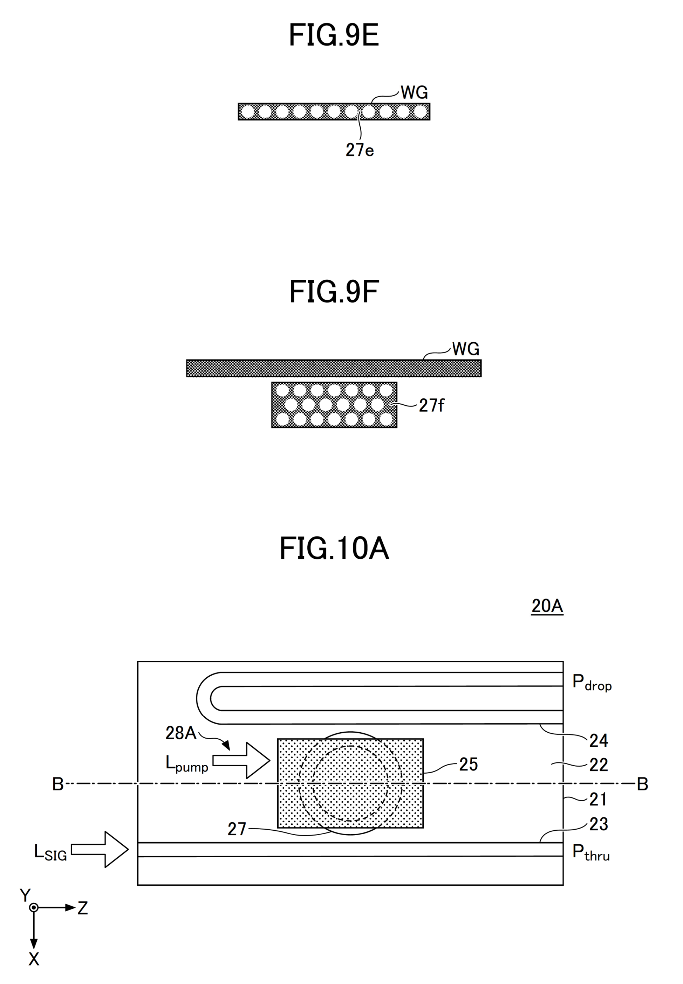

FIG. 9A to FIG. 9F illustrate resonators provided over the substrate 21. FIG. 9A illustrates a resonator 27a that is a racetrack ring resonator. The resonator 27a is disposed between two optical waveguides WG, but may be disposed in proximity to one first optical waveguide 23 as illustrated in FIG. 6A and FIG. 6B. FIG. 9B illustrates a resonator 27b that is a circular ring resonator. FIG. 9C illustrates a resonator 27c that is a disk resonator. The resonance wavelength of each of the resonators of FIG. 9A to FIG. 9C is determined by the perimeter and the effective refractive index of the material. FIG. 9D illustrates an optical waveguide WG and a resonator 27d formed in a two-dimensional photonic crystal. A region in which a periodic pattern is formed constitutes the resonator 27d. A region without a pattern and without the resonator 27d constitutes the optical waveguide WG. FIG. 9E illustrates an optical waveguide WG and a resonator 27e formed in a one-dimensional photonic crystal. A waveguide region having a one-dimensional periodic pattern serves as the optical waveguide WG and the resonator 27e. FIG. 9F illustrates a resonator 27f that is a photonic-crystal resonator disposed in proximity to an optical waveguide WG. The resonance wavelength of each of the resonators of FIG. 9D to FIG. 9F is determined by the period (lattice spacing) and the structure of a pattern.

The resonators 27a to 27c of FIG. 9A to FIG. 9C can be formed by the same process as the first optical waveguide 23 over the substrate 21. The semiconductor CNT can be easily formed by a printing method or the like on the resonator 27 formed by the same process as the first optical waveguide 23. A ring resonator, a disk resonator, or a racetrack resonator is preferable from the viewpoint of ease of a manufacturing process and ability to mount a large number of CNTs. As in the case of a photonic-crystal resonator or a nanobeam resonator, a resonator having a structure using a photonic crystal, such as the resonators 27d to 27f, can be formed on the same line as an optical waveguide WG, or a photonic-crystal resonator can be formed in proximity to an optical waveguide WG such that the photonic-crystal resonator is coupled to the optical waveguide WG.

As described above, in a case where the resonator 27 is a ring resonator, a disk resonator, a racetrack resonator, or a toroid resonator, the resonance wavelength of the resonator 27 is determined by the perimeter and the effective refractive index of the resonator 27. More specifically, in a simplified model, light resonates when the product of the perimeter and the effective refractive index of the resonator 27 is an integer multiple of the wavelength of the light. The resonator 27 is disposed with a predetermined gap from the first optical waveguide 23. The coupling efficiency between the first optical waveguide 23 and the resonator 27 is determined by the gap and the coupling length between the first optical waveguide 23 and the resonator 27. Of signal light L_{SIG} incident into and propagating through the first optical waveguide 23, light corresponding to the resonance wavelength (or an integral multiple of the resonance wavelength) is coupled to the resonator 27. The light circulated in the resonator 27 and amplified to a constant power level is coupled to the first optical waveguide 23 and output from an output port Pₒᵤₜ. The degree to which signal light can be coupled to the resonator or the degree to which amplified light can be extracted can be controlled by the degree of coupling between the resonator and the waveguide.

The excitation structure 28 irradiates the semiconductor CNT layer 25 covering the resonator 27 with excitation light Lₚᵤₘₚ. The excitation structure 28 may irradiate the semiconductor CNT layer 25 with the excitation light Lₚᵤₘₚ from above the substrate 21 as in the excitation structures 18C and 18D illustrated in FIG. 4A and FIG. 4B. Alternatively, as in FIG. 3A and FIG. 3B, the excitation light Lₚᵤₘₚ may be coupled to the resonator 27 from the first optical waveguide 23 over the substrate 21. As in FIG. 3A, a second optical waveguide for excitation light introduction may be formed over the substrate 21. Alternatively, as in FIG. 3B, excitation light and signal light may be incident into an optical waveguide over the substrate 21 by using an optical fiber and a fiber coupler. The optical amplifier 20 is advantageous because the optical amplifier 20 can selectively amplify and output light having a desired wavelength with a very simple configuration.

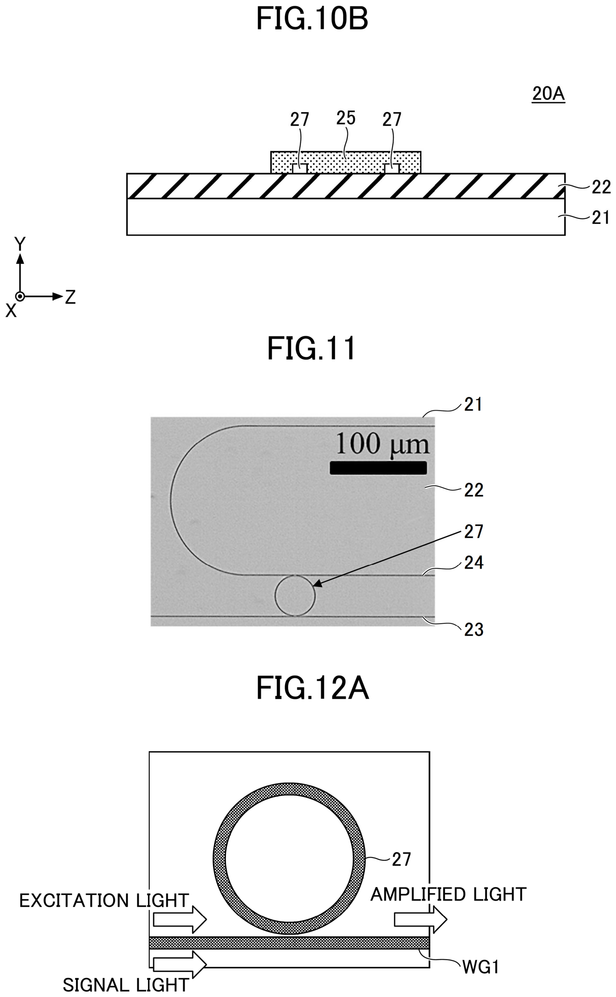

FIG. 10A is a schematic plan view of an optical amplifier 20A according to a modification of the second embodiment. FIG. 10B is a cross-sectional view taken along the line B-B of FIG. 10A. The optical amplifier 20A includes a substrate 21, a first optical waveguide 23 formed over the substrate 21, a resonator 27 disposed over the substrate 21 and configured to be optically coupled to the first optical waveguide 23, a semiconductor CNT layer 25 covering a portion of or the entirety of the resonator 27, and an excitation structure 28A configured to excite the semiconductor CNT layer 25.

In addition to the first optical waveguide 23, the optical amplifier 20A includes a third optical waveguide 24, which is an output waveguide, over the substrate 21. The third optical waveguide 24 is optically coupled to the resonator 27 at a position different from a position at which the first optical waveguide 23 is optically coupled to the resonator 27. The first optical waveguide 23 is connected to a through port Pₜₕᵣᵤ, and the third optical waveguide 24 is connected to a drop port P_{drop}. Signal light L_{SIG} propagating through the first optical waveguide 23 is amplified by the resonator 27 optically coupled to the first optical waveguide 23. The light amplified by the resonator 27 returns to the first optical waveguide 23 and is output from the through port Pₜₕᵣᵤ. Further, the light amplified by the resonator 27 is guided to the third optical waveguide 24 optically coupled to the resonator 27 and is output from the drop port P_{drop}. The drop port P_{drop} outputs light that is coupled to the resonator 27 from the first optical waveguide 23, amplified by the resonator 27, and then coupled to the third optical waveguide 24. An output port of the amplified light can be switched between the through port and the drop port.

The excitation structure 28A excites the semiconductor CNT layer 25 covering the resonator 27 with excitation light Lₚᵤₘₚ. The excitation structure 28A may irradiate the semiconductor CNT layer 25 with the excitation light Lₚᵤₘₚ from above the substrate 21 as in the excitation structure 18C or 18D of FIG. 4A or FIG. 4B. Alternatively, as in the excitation structure 18A or 18B of FIG. 3A or FIG. 3B, the excitation light Lₚᵤₘₚ may be into the first optical waveguide 23 over the substrate 21 such that the excitation light Lₚᵤₘₚ is coupled to the resonator 27. In the latter case, as illustrated in FIG. 3A, a second optical waveguide, configured to guide the excitation light Lₚᵤₘₚ emitted from an excitation light source 16 over the substrate 21, may be formed over the substrate 21 and coupled to the first optical waveguide 23 by a coupler. Alternatively, as illustrated in FIG. 3B, the signal light and the excitation light may be multiplexed by the optical fiber coupler 163 outside the substrate 21, and may be introduced into the first optical waveguide 23 over the substrate 21. Alternatively, two incident ports may be prepared on the substrate 21, and the signal light and the excitation light may be separately introduced and then multiplexed on the substrate 21.

In a state in which electrons in the semiconductor CNT layer 25 covering the resonator 27 are excited by the excitation light Lₚᵤₘₚ, the signal light L_{SIG} is input into the first optical waveguide 23. A light component of the signal light L_{SIG} that does not conform to the resonance wavelength of the resonator 27 may be output from the through port Pₜₕᵣᵤ. The signal light L_{SIG} corresponding to the resonance wavelength and coupled to the resonator 27 in the excited state causes stimulated emission by the incidence of the signal light L_{SIG}, is amplified, is coupled to the third optical waveguide 24, and is output from the drop port P_{drop}.

Because the configuration illustrated in FIG. 10A and FIG. 10B includes the through port Pₜₕᵣᵤ and the drop port P_{drop}, a transmission measurement and an amplification measurement of the resonator 27 can be simultaneously performed. Further, because the first optical waveguide 23 and the third optical waveguide 24 are optically coupled to the resonator 27, the signal light L_{SIG} and the excitation light Lₚᵤₘₚ can be confined in the resonator 27, and amplified light Lₐₘₚ can be extracted. By using two or more optical waveguides, the optical coupling states of the first optical waveguide 23, the third optical waveguide 24, and the resonator 27 can be optimally designed in accordance with the characteristics or wavelengths of the required signal light L_{SIG} and the excitation light Lₚᵤₘₚ. Thus, higher performance can be achieved by more precise design.

FIG. 11 is an image of the optical waveguides used in the optical amplifier 20A of FIG. 10A and FIG. 10B. In this example, the substrate 21 is a silicon substrate or an SOI substrate, and the first optical waveguide 23, the resonator 27, and the third optical waveguide 24 are formed of Si wires. The width and the height of the Si wires are, for example, 0.1 µm to 1.0 µm, and the width and the height of the Si wires can be appropriately designed according to the application. The resonator 27 is a ring resonator and has a diameter of 40 µm. A gap between the resonator 27 and each of the first optical waveguide 23 and the third optical waveguide 24 is 150 nm. The semiconductor CNT layer 25 is disposed to cover a portion of or the entirety of the resonator 27, which is the Si wire (see FIG. 10A and FIG. 10B). The semiconductor CNT layer 25 is easily formed by a printing method or the like.

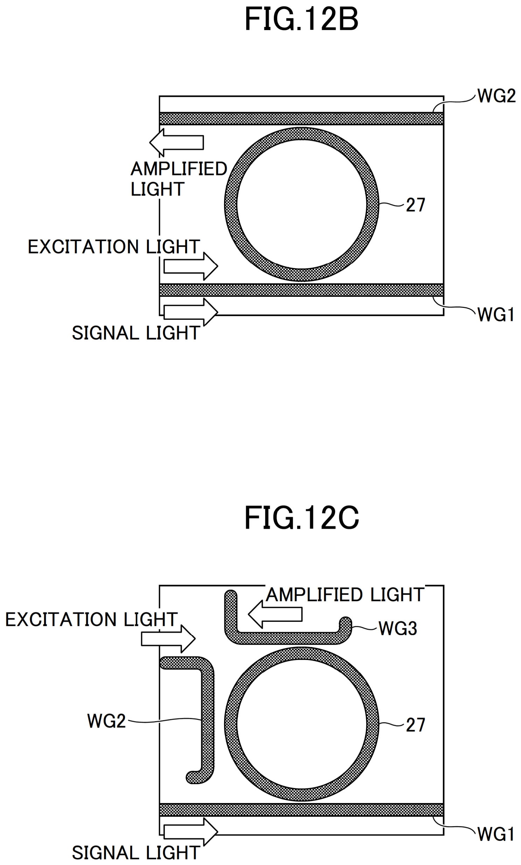

Each of FIG. 12A and FIG. 12B illustrates an example output configuration of amplified light. For clarity, each of FIG. 12A and FIG. 12B illustrates a state before a semiconductor CNT layer is provided. In a case where excitation light and signal light are incident into optical waveguide(s) and amplified light is extracted from an optical waveguide, various configurations are possible in accordance with the number of optical waveguides. In FIG. 12A, one optical waveguide WG1 and a ring resonator 27 are provided. Excitation light and signal light are incident into the one optical waveguide WG1, and amplified light is extracted from the same optical waveguide WG1 in the same direction. In FIG. 12B, a ring resonator 27 is disposed between two optical waveguides WG1 and WG2. Signal light and excitation light are incident into the one optical waveguide WG1, and amplified light is extracted from the other optical waveguide WG2. In FIG. 12C, three optical waveguides WG1, WG2, and WG3 and a ring resonator 27 are used. Signal light is incident into the optical waveguide WG1, excitation light is incident into the optical waveguide WG2, and amplified light is extracted from the third optical waveguide WG3. In any of the above configurations, when at least a portion of the resonator 27 is covered by a semiconductor CNT layer 25 (see FIG. 10A and FIG. 10B), signal light is amplified by an excited state of electrons in the semiconductor CNT and stimulated emission resulting from the incidence of the signal light. The optical amplifier 20 has a high degree of freedom in design.

### <Third Embodiment>

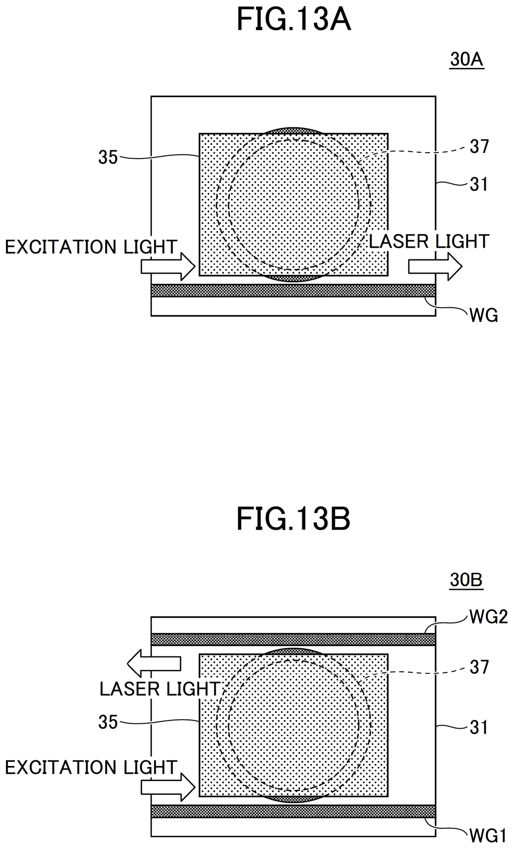

FIG. 13A and FIG. 13B are schematic views of laser light sources according to a third embodiment. In the third embodiment, the optical amplifier 20 according to the second embodiment is applied to a laser light source. That is, a laser light source is manufactured by using optical amplification by stimulated emission. FIG. 13A is a schematic view of a laser light source 30A using one optical waveguide WG and a resonator 37. FIG. 13B is a schematic view of a laser light source 30B using two optical waveguides WG1 and WG2 and a resonator 37. In each of the laser light sources, a semiconductor CNT layer 35 is provided so as to cover at least a portion of a corresponding resonator 37.

In each of the laser light sources 30A and 30B, incident of signal light is not required. When light emission is obtained from the semiconductor CNT by excitation of carriers by excitation light, laser light is generated by stimulated emission resulting from a population inversion of the semiconductor CNT and light confinement by the resonator 37. When the electronic state of the semiconducting CNT is brought into a population inversion state by the excitation of carriers and light is confined in the resonator, phase-coherent light is amplified by stimulated emission, and laser light is emitted. In the example configuration illustrated in each of FIG. 13A and FIG. 13B, excitation light is incident into an optical waveguide, but the excitation light may be emitted from above the resonator 37. Laser light generated by stimulated emission is coupled from the resonator 37 to the optical waveguide WG or the optical waveguide WG2 and is emitted. Unlike narrow-linewidth emission of spontaneous emission light caused by simple resonance using a similar resonator, the laser light generated by the configuration illustrated in each of FIG. 13A and FIG. 13B is laser light generated by amplification through stimulated emission.

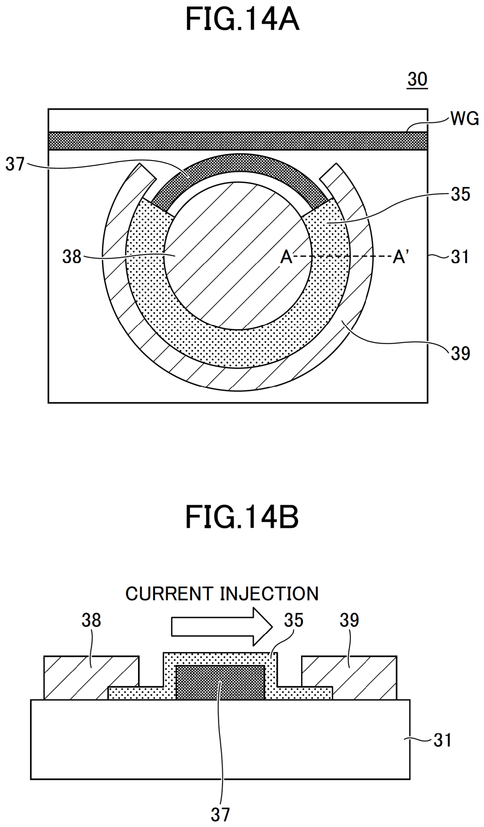

FIG. 14A and FIG. 14B are schematic views of a laser light source 30 by current injection. FIG. 14A is a schematic plan view of the laser light source. FIG. 14B is a cross-sectional view taken along the line A-A' of FIG. 14A. Light generated by excitation of carriers by current injection may be amplified by a resonator covered by a semiconductor CNT to cause laser oscillation. The laser light source 30 includes an optical waveguide WG, a resonator 37 disposed in proximity to the optical waveguide WG, and a semiconductor CNT layer 35 covering at least a portion of the resonator 37. In this example, the resonator 37 is a ring resonator. For example, the semiconductor CNT layer 35 is disposed following the ring of the resonator 37, and is connected to an electrode 38 provided inside the resonator 37 and to an electrode 39 provided following the outer periphery of the resonator 37. When the electrodes 38 and 39 are energized, carriers are injected into the semiconductor CNT layer 35 from the electrodes 38 and 39, and electroluminescence light emission is obtained by current injection. By confining this light emission in the resonator 37 and bringing the electronic state of the semiconductor CNT layer 35 into a population inversion state, laser oscillation occurs by stimulated emission. In the configuration of FIG. 14A and FIG. 14B, since light emission by current injection is utilized, excitation light is not required. For light emission by current injection, electron-hole injection excitation can be used, or excitation by collision of either holes or electrons can be used. The excitation of the laser light sources according to the third embodiment is not limited to optical excitation illustrated in FIG. 13A and FIG. 13B or current-excitation illustrated in FIG. 14A and FIG. 14B. Seed light may be incident into the semiconductor CNT layer 35 and amplified by stimulated emission to cause laser oscillation.

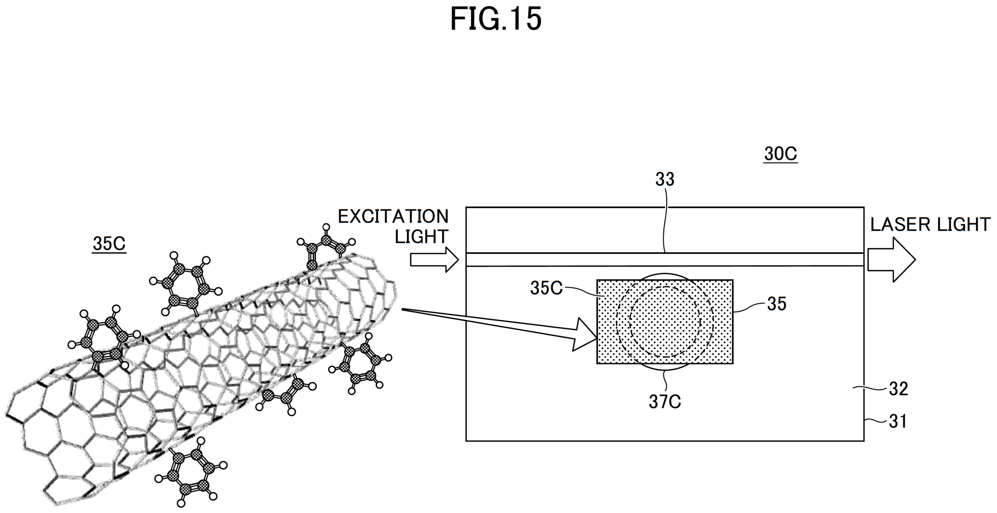

FIG. 15 illustrates a laser light source 30C using a molecularly modified carbon nanotube according to a modification of the third embodiment. A molecularly modified CNT may be used as a semiconductor CNT to generate laser light by stimulated emission using molecular modification. The laser light source 30C includes a waveguide 33 disposed over a substrate 31 via an insulating layer 32, a resonator 37C disposed in proximity to the waveguide 33, and a semiconductor CNT layer 35C covering at least a portion of the resonator 37C. In this example, a ring resonator is used as the resonator 37, but any of the resonators illustrated in FIG. 9A to FIG. 9F may be used. The semiconductor CNT layer 35C covering the resonator 37C is a molecularly modified CNT layer. Examples of a carbon nanotube modified with a molecule that can be used include nanotubes modified with atoms such as oxygen and hydrogen, and nanotubes modified with molecules including aryl groups such as iodobenzene and nitrobenzenediazonium, dibromoalkanes, alkyl groups such as tert-butyl, OH groups, carboxyl groups, and the like. In addition, the surface of the CNT may be modified with metal nanoparticles by a laser ablation method. Deep levels are created in the band gap by molecular modification, and exciton levels localized in these deep levels are present. The deep levels can efficiently form a population inversion state, and stimulated emission is promoted. The promotion of stimulated emission enhances the optical gain.

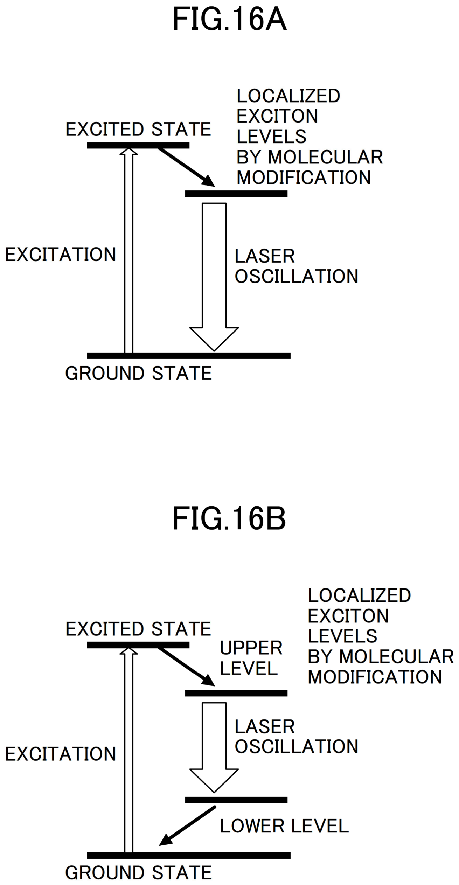

FIGS. 16A and 16B are energy diagrams each illustrating laser oscillation from localized exciton levels by a molecularly modified CNT. FIG. 16A illustrates laser oscillation from a three-level system. FIG. 16B illustrates laser oscillation from a four-level system. Laser oscillation from localized exciton levels enables highly efficient optical amplification and laser oscillation. Although the molecularly modified CNT is applied to laser oscillation in each of FIG. 16A and FIG. 16B, the molecularly modified CNT may be applied to each of the optical amplifier 10 according to the first embodiment and the optical amplifier 20 according to the second embodiment. The performance of an optical amplifier can be improved by using the molecularly modified CNT.

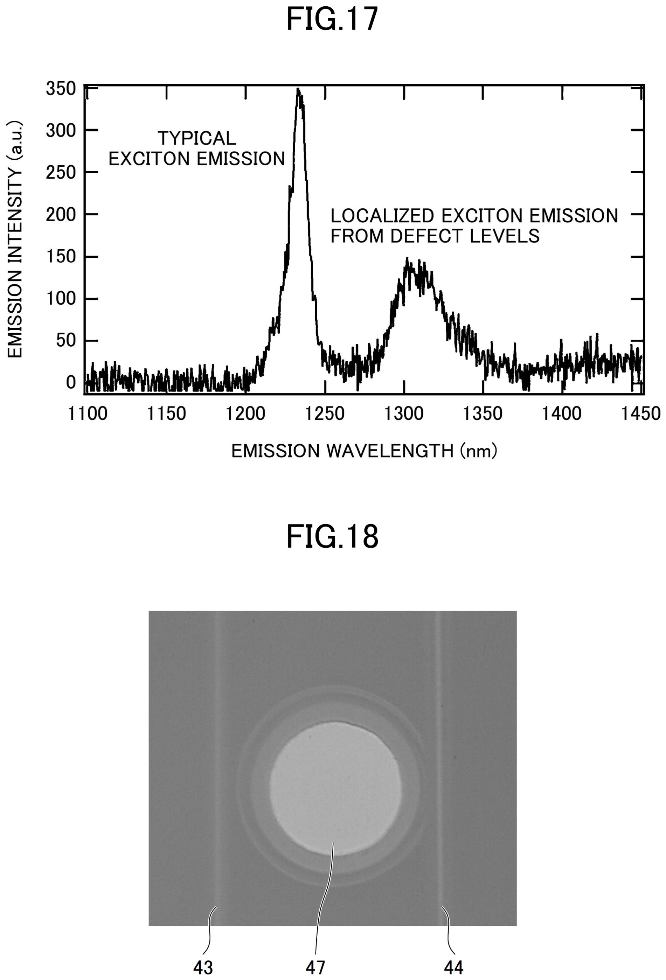

FIG. 17 is an emission spectrum diagram of a molecularly modified CNT. As the molecularly modified CNT, a carbon nanotube modified with iodobenzene is used. Typical exciton emission is obtained at the short wavelength side, and in addition to this, localized exciton emission with low energy, which is caused by molecular modification, is obtained. By using the above, the three-level system and the four-level system as illustrated in FIG. 16A and FIG. 16B can be formed. By forming the molecularly modified CNT in a resonator, an optical amplifier and a laser light source with high efficiency can be produced.

### <Other Example Configurations>

FIG. 18 is an image illustrating an example configuration using a toroid resonator 47 and optical fibers 43 and 44. In this example, waveguides formed by two tapered fibers are formed for the toroid resonator formed of silicon oxide. By applying a semiconductor CNT layer to such a configuration, an optical amplifier and a laser light source can be produced.

The above disclosure includes the following aspects.
(Clause 1) An optical amplifier including:
   a substrate;
   a first optical waveguide formed over the substrate;
   a semiconductor carbon nanotube layer covering a predetermined region of the first optical waveguide; and
   an excitation structure configured to excite the semiconductor carbon nanotube layer, wherein
   signal light is amplified by an excited state of electrons in the semiconductor carbon nanotube layer and stimulated emission resulting from incidence of the signal light into the predetermined region.
(Clause 2) The optical amplifier according to clause 1, further including:
   a resonator configured to be optically coupled to the first optical waveguide, wherein
   the semiconductor carbon nanotube layer covers at least a portion of the resonator, and
   the signal light is coupled to the resonator and amplified by the stimulated emission.
(Clause 3) The optical amplifier according to clause 2, wherein the first optical waveguide is connected to an output port configured to output the signal light amplified by the resonator in a propagation direction of the signal light.
(Clause 4) The optical amplifier according to clause 2, further comprising:
   an output waveguide configured to be optically coupled to the resonator at a position different from a position at which the first optical waveguide is optically coupled to the resonator, wherein
   the output waveguide is connected to an output port configured to output the signal light amplified by the resonator.
(Clause 5) The optical amplifier according to any one of clauses 1 to 4, wherein
   the excitation structure includes a second optical waveguide configured to multiplex excitation light, emitted from an excitation light source, into the first optical waveguide over the substrate, wherein
   the electrons in the semiconductor carbon nanotube layer are excited by causing the excitation light incident from the second optical waveguide into the predetermined region of the first optical waveguide to be evanescently coupled to the semiconductor carbon nanotube layer.
(Clause 6) The optical amplifier according to any one of clauses 1 to 4, wherein the excitation structure is configured to irradiate, from above the substrate, the semiconductor carbon nanotube layer with excitation light emitted from an excitation light source, and excite the electrons in the semiconductor carbon nanotube layer by the irradiation with the excitation light.
(Clause 7) The optical amplifier according to any one of clauses 1 to 6, wherein the semiconductor carbon nanotube layer is a molecularly modified carbon nanotube layer.
(Clause 8) The optical amplifier according to any one of clauses 1 to 7, wherein the substrate is a silicon substrate, and the first optical waveguide is a silicon wire waveguide.
(Clause 9) A laser light source including:
   a substrate;
   a first optical waveguide formed over the substrate;
   a resonator disposed over the substrate and configured to be optically coupled to the first optical waveguide;
   a semiconductor carbon nanotube layer covering a portion or an entirety of the resonator; and
   an excitation structure configured to excite the semiconductor carbon nanotube layer, wherein
   the resonator confines light generated by excitation of carriers by the excitation structure, and
   the first optical waveguide outputs laser light generated by the confinement of the light by the resonator and stimulated emission resulting from a population inversion of the semiconducting carbon nanotube layer.
(Clause 10) The laser light source according to clause 9, wherein the semiconductor carbon nanotube layer is a molecularly modified carbon nanotube layer.
(Clause 11) The laser light source according to clause 9 or 10, wherein the excitation structure excites the carriers by optical excitation or current excitation.

This application is based on and claims priority to Japanese Patent Application No. 2023-081418, filed on May 17, 2023, and Japanese Patent Application No. 2023-173140, filed on October 4, 2023, the entire contents of which are incorporated herein by reference.

### DESCRIPTION OF THE REFERENCE NUMERALS

10, 10A, 10B, 10C, 10D, 20, 20A optical amplifier
11, 21 substrate
12 insulating layer
14, 23 first optical waveguide
141 signal light input optical waveguide
142 second optical waveguide
15, 25, 35, 35C semiconductor CNT layer
18, 18A, 18B, 18C, 18D, 28, 28A excitation structure
24 third optical waveguide
27, 27a to 27f, 37 resonator
30, 30A, 30B, 30C laser light source
38, 39 electrode
L_{SIG} signal light
Lₚᵤₘₚ excitation light
Lₐₘₚ amplified light Lamp
Pₒᵤₜ output port
Pₜₕᵣᵤ through port
P_{drop} drop port

## Claims

1. An optical amplifier comprising:
a substrate;
a first optical waveguide formed over the substrate;
a semiconductor carbon nanotube layer covering a predetermined region of the first optical waveguide; and
an excitation structure configured to excite the semiconductor carbon nanotube layer, wherein
signal light is amplified by an excited state of electrons in the semiconductor carbon nanotube layer and stimulated emission resulting from incidence of the signal light into the predetermined region.

2. The optical amplifier according to claim 1, further comprising:
a resonator configured to be optically coupled to the first optical waveguide, wherein
the semiconductor carbon nanotube layer covers at least a portion of the resonator, and
the signal light is coupled to the resonator and amplified by the stimulated emission.

3. The optical amplifier according to claim 2, wherein the first optical waveguide is connected to an output port configured to output the signal light amplified by the resonator in a propagation direction of the signal light.

4. The optical amplifier according to claim 2, further comprising:
an output waveguide configured to be optically coupled to the resonator at a position different from a position at which the first optical waveguide is optically coupled to the resonator, wherein
the output waveguide is connected to an output port configured to output the signal light amplified by the resonator.

5. The optical amplifier according to claim 1, wherein
the excitation structure includes a second optical waveguide configured to multiplex excitation light, emitted from an excitation light source, into the first optical waveguide over the substrate, and
the electrons in the semiconductor carbon nanotube layer are excited by causing the excitation light incident from the second optical waveguide into the predetermined region of the first optical waveguide to be evanescently coupled to the semiconductor carbon nanotube layer.

6. The optical amplifier according to claim 1, wherein the excitation structure is configured to irradiate, from above the substrate, the semiconductor carbon nanotube layer with excitation light emitted from an excitation light source, and excite the electrons in the semiconductor carbon nanotube layer by the irradiation with the excitation light.

7. The optical amplifier according to claim 1, wherein the semiconductor carbon nanotube layer is a molecularly modified carbon nanotube layer.

8. The optical amplifier according to claim 1, wherein the substrate is a silicon substrate, and the first optical waveguide is a silicon wire waveguide.

9. A laser light source comprising:
a substrate;
a first optical waveguide formed over the substrate;
a resonator disposed over the substrate and configured to be optically coupled to the first optical waveguide;
a semiconductor carbon nanotube layer covering a portion or an entirety of the resonator; and
an excitation structure configured to excite the semiconductor carbon nanotube layer, wherein
the resonator confines light generated by excitation of carriers by the excitation structure, and
the first optical waveguide outputs laser light generated by the confinement of the light by the resonator and stimulated emission resulting from a population inversion of the semiconducting carbon nanotube layer.

10. The laser light source according to claim 9, wherein the semiconductor carbon nanotube layer is a molecularly modified carbon nanotube layer.

11. The laser light source according to claim 9, wherein the excitation structure excites the carriers by optical excitation or current excitation.
